Europäisches Patentamt

European Patent Office

Office européen des brevets

(11) Publication number: **0 309 169**
**A2**

# EUROPEAN PATENT APPLICATION

(21) Application number: **88308601.9**

(22) Date of filing: **16.09.88**

(51) Int. Cl.4: **H01L 39/24 , C04B 35/50**

(30) Priority: **24.09.87 GB 8722536**
**22.10.87 GB 8724761**
**29.04.88 GB 8810200**

(43) Date of publication of application:
**29.03.89 Bulletin 89/13**

(84) Designated Contracting States:
**AT BE CH DE ES FR GB IT LI LU NL SE**

(71) Applicant: **IMPERIAL CHEMICAL INDUSTRIES PLC**
**Imperial Chemical House Millbank**
**London SW1P 3JF(GB)**

(72) Inventor: **Alford, Neil McNeil**
**49a Daleside Upton**
**Chester(GB)**
Inventor: **Birchall, James Derek**
**Braeside Stable Lane**
**Mouldsworth Cheshire(GB)**
Inventor: **Clegg, William John**
**53 Appleton Road Upton**
**Chester(GB)**
Inventor: **Harmer, Mark Andrew**
**10 School Lane Overton**
**Frodsham(GB)**
Inventor: **Kendall, Kevin**
**7 Whiteley Close**
**Runcorn Cheshire(GB)**

(74) Representative: **Walmsley, David Arthur**
**Gregson et al**
**Imperial Chemical Industries PLC Legal**
**department: Patents PO Box 6 Bessemer**
**Road**
**Welwyn Garden City Hertfordshire AL7**
**1HD(GB)**

(54) Superconducting shaped article.

(57) A shaped article which possesses the property of superconductivity and which comprises a mixture of an organic polymeric material and a particulate superconducting material of the ceramic type.

EP 0 309 169 A2

## SUPERCONDUCTING SHAPED ARTICLE

This invention relates to a superconducting shaped article, and to a process for the production of such an article.

The phenomenon of superconductivity, that is the complete loss of electrical resistance of a material, has been known for many years. Very many elements and alloys are known to possess the property of superconductivty, for example niobium and alloys of niobium, and superconductivity has generally been considered to be a property possessed by certain elements when in the metallic state. Whilst materials which possess the property of superconductivity potentially have very many applications, for example, in electrical power transmission lines which in use result in little or no loss of power, in electric motors, in magnetic levitation applications such as in transportation systems which operate on the magnetic levitation principle, in scientific instruments, e.g. in superconducting quantum interference devices (SQUIDS), and in structures for use in magnetic screening, e.g. in the screening of electrical equipment, the application of such materials has been severely limited as until recently superconductivity could be attained only at extremely low temperatures. The temperatures at which superconductivity could be attained, that is the critical temperature, Tc, were generally below $23^\circ$K and such temperatures can be attained only by using liquid helium as a coolant. Such extremely low temperatures, and the expense of liquid helium as a coolant, limited the practical application of the phenomenon of superconductivity to uses in scientific instruments, such as in as nuclear magnetic research scanners.

In a more recent development the phenomenon of superconductivity has been observed in certain non-metallic materials and at substantially higher temperatures than those at which superconductivity has been observed hitherto. In particular, the phenomenon of superconductivity has been observed in certain non-metallic materials at temperatures as high as $77^\circ$K, or even higher, that is at temperatures which are attainable by cooling with liquid nitrogen. The fact that superconductivity is attainable at such relatively high temperatures, and the fact that the required coolant is the relatively inexpensive liquid nitrogen, has opened up the possibility of much more widespread practical applications of the phenomenon of superconductivity than have been possible hitherto.

In Z. Phys. B. - Condensed Matter, 64, pp 189-193 (1986) J. G. Bednorz and K. A. Muller reported the preparation of coprecipitated and heat treated mixtures of lanthanum, barium, copper and oxygen and they reported that the mixtures showed superconductivity at a critical temperature higher than the critical temperatures which had been observed hitherto for metals and alloys. The mixtures were reported to have a composition $La_{5-x}$ $Ba_x$ $Cu_5$ $O_{5(3-y)}$ where x = 0.75 to 1 and Y>0, and the compositions were prepared by coprecipitation from barium-, lanthanum- and copper nitrate solutions by addition to an oxalic acid solution followed by decomposition and solid state reaction at $900^\circ$C for 5 hours and sintering in an oxygen atmosphere.

In published European Patent Application 0 275 343 there is described a superconductive compound having a critical temperature above $28^\circ$K, and which may be as high as $35^\circ$K. The compound is of the $RE_2TMO_4$. type wherein the rare earth element (RE) is partially substituted by one or more alkaline earth metal elements (AE) and wherein the oxygen contents is adjusted such that the resulting crystal structure is distorted and comprises a phase of the general compositions $RE_{2-x}$ $AE_xTMO_{4-y}$, wherein TM represents a transition metal and x<0.3 and y<0.5. A favoured rare earth element is lanthanum, a favoured alkaline earth element is barium, and a favoured transition metal is copper.

In International Patent Application No PCT/US 87/02958, International Publication No WO 88/05029, there is described a composition which is superconducting at a temperature of $40^\circ$K and higher, and which comprises a sintered metal oxide complex of the formula

$[L_{1-x}M_x]_aA_bO_y$

in which L is yttrium, lanthanum, cerium, preasodymium, neodymium, samarium, europium, gadolinium, terbium, dysprosium, holmium, erbium, thulium, ytterbium, or lutetium, or a combination thereof. M is barium, strontium, calcium, magnesium, mercury, or a combination thereof provided that when L is lanthanum M is not barium, A is copper, bismuth, tungsten, zirconium, tantalum, niobium, or vanadium, x is from about 0.01 to 1.0, a is 1 to 2, b is 1, and y is about 2 to 4.

In the aforementioned International Publication there is also described the production of the sintered metal oxide complex by heating a mixture of solid compounds containing L, M, A and O in proportions appropriate to yield the aforementioned formula to a temperature of 640-800$^\circ$C in an oxygen atmosphere and for a time sufficient to react the mixture in the solid state and then heating the mixture at 900-1100$^\circ$C for a period of at least about 12 hours subsequent to the reaction, pelletizing the mixture, and sintering the pellets. With certain of the sintered metal oxide complexes a critical temperature as high as 100° K has been observed. A preferred sintered metal oxide complex is that in which L is yttrium, M is barium, and A is copper and one phase of such a preferred material which has been identified as having a high critical temperature is that having empirical formula $YBa_2Cu_3O_x$ where x is typically between 6.5 and 7.2.

These materials which have critical temperatures above those which have previously been observed with metallic materials have the characteristics of ceramic materials, that is they can be formed into monolithic structures by sintering of the materials when in particulate form, and at least in this way they are distinguished from metallic materials. Thus, shaped articles may be produced from the particulate superconducting materials by processes which are conventional in the ceramics processing art, for example, by powder pressing, by isostatic pressing or by slip casting. For example, the particulate ceramic material may be pressed in a mould into a desired shape at elevated pressure and the material may be heated at elevated temperature in an oxygen-containing atmosphere, e.g. in air at a temperature of the order of 900 to 950° C or higher, in order to sinter together the particles of ceramic material. The thus sintered shaped article may then be cooled slowly to ambient temperature in an oxygen-containing atmosphere, and during the cooling process the shaped article may be annealed, for example at a temperature of approximately 450° C. Shaped articles produced by such a process are generally very brittle and generally have densities which are substantially below the theoretical maximum density.

The present invention relates to a shaped article which exhibits the phenomenon of superconductivity and which comprises a particulate superconducting material but which does not consist solely or even essentially of such a material, to a shaped article which is less brittle than is a shaped article which has been produced hitherto from such particulate material, and to a process for producing the shaped article in which it is unnecessary to sinter together the particles of superconducting material. The invention also provides a process for producing such a shaped article by means of which a shaped article may be produced which is of greater size and more complex shape than can generally be produced by the processes described hitherto.

According to the present invention there is provided a shaped article which possesses the property of superconductivity and which comprises a mixture of an organic polymeric material and a particulate superconducting material of the ceramic type.

The particulate superconducting material of the ceramic type in the shaped article of the invention has the property of being superconducting at a temperature below the so-called critical temperature for the material, that is, at a temperature below the critical temperature the material has substantially zero electrical resistivity. On the other hand, the shaped article of the invention is superconducting at a temperature below the critical temperature in the sense that the shaped article exhibits the Meissner effect at such a temperature, that is the shaped article excludes magnetic flux lines when it is immersed in a magnetic field at a temperature below the critical temperature. Whether or not the shaped article is also superconducting in the sense of exhibiting zero electrical resistivity at a temperature below the critical temperature depends on a number of factors, including the proportion of particulate superconducting material in the shaped article. It is preferred that the shaped article is also superconducting in the sense of having zero electrical resistivity at a temperature below the critical temperature.

The invention also provides a process for the production of a shaped article which possesses the property of superconductivity which process comprises forming a mixture of an organic material, which is polymeric or which is polymerisable, and a particulate superconducting material of the ceramic type, shaping the composition, and if necessary polymerising the organic material.

The shaped article of the invention may comprise any suitable particulate superconducting material of the ceramic type but it is preferred that the superconducting material is a material which itself exhibits superconductivity at a relatively high temperature, that is which has a relatively high critical temperature, and specifically that it be superconducting at a temperature which is not lower than the boiling point of nitrogen at normal temperature and pressure, that is at a temperature which is not lower than 77° K. Such materials are preferred as the coolant which is required in order to attain superconductivity in the shaped article, liquid nitrogen, is relatively inexpensive when compared with coolants such as liquid helium which are required when the particulate material in the shaped article of the invention exhibits superconductivity only at much lower temperatures. Furthermore, where the material exhibits superconductivity at the temperature of liquid nitrogen there are potentially much more widespread practical applications for shaped articles of the invention comprising the particulate superconducting material. However, the use of particulate materials which exhibit superconductivity and thus have a critical temperature only at temperatures lower than 77° K is not excluded from the invention.

Preferred particulate superconducting materials are the ceramic materials of the oxide type and which comprise at least one element of the lanthanide series, including lanthanum itself and scandium and yttrium, at least one alkaline earth element, e.g. magnesium, calcium, strontium, or barium, and at least one transition element, e.g. copper, titanium, tungsten, zirconium, tantalum, niobium, or vanadium. The particulate superconducting material may have a formula as hereinbefore referred to with respect to International Publication No WO 88/05029, and indeed in the aforementioned formula when L is lanthanum M may be barium.

A particulate superconducting material which is preferred as it has a particularly high critical temperature is a yttrium-barium-copper oxide material, for example, the material having the composition $YBa_2Cu_3O_x$ where x is between 6.5 and 7.2, as this material has a high critical temperature, which may be above the boiling point of liquid nitrogen, that is above 77° K. Another particulate superconducting material of the oxide type which may be mentioned is that comprising lanthanum-barium-copper oxide, although the invention is not limited to use with any specific superconducting material of the ceramic type, nor to any specific such material of the oxide type, and many such materials may be used in the shaped article of the invention.

It is to be understood that in the particulate superconducting material of the ceramic type in the shaped article of the invention several distinct phases may be present some of which may be superconducting and some of which may not be superconducting.

The particulate superconducting material may have any convenient particle size provided that the sizes of the particles, and the distribution of particle sizes, is such that the particles can be mixed homogeneously with the organic material and shaped to form the shaped article of the invention. A suitable particle size is not greater than 500 microns preferably not greater than 100 microns, for example a size in the range 100 to 0.001 microns. The particulate superconducting material may have a plurality of particle sizes, and such a plurality of sizes is especially important in the achievement of good particle packing and consequently a high proportion of particulate material in the shaped article of the invention.

Methods for producing the particulate superconducting material of the ceramic type which forms a part of the shaped article do not themselves form a part of the present invention. However, such superconducting materials of the oxide type may be produced in particulate form by forming a mixture of the oxides of the desired elements in the required proportions, and/or a mixture of decomposible precursors of the oxides of the desired elements, e.g. a mixture of carbonates and/or nitrates, heating the mixture at an elevated temperature in an oxygen-containing atmosphere, e.g. at a temperature of 900 to 950° C or higher in oxygen, for a time which is of the order of 12 to 24 hours, and subsequently cooling the thus formed ceramic material and grinding the material to convert it into the desired particulate form.

The organic material in the shaped article of the invention is a polymeric material, and the shaped article may be produced from a mixture of particulate superconducting material and organic polymeric material, or from a mixture of such a particulate material and polymerisable organic material which may subsequently be polymerised to form a polymeric material.

Where the shaped article is produced by mixing a particulate superconducting material and an organic polymeric material and shaping the mixture the latter material may be a thermoplastic material which is preferably melt processable. Suitable thermoplastic materials include polyolefins; e.g. polyethylene and polypropylene; and halogen-containing polyolefins, e.g. polyvinyl chloride, polyvinylidene chloride, and fluorine-containing organic polymers. The thermoplastic organic polymeric material may be an elastomeric material, e.g. a natural or synthetic elastomer, for example ethylene-propylene copolymer or an ethylene-propylene-diene copolymer. Many other types of thermoplastic organic polymeric materials, may be used in the production of the shaped article of the invention.

Where the organic material is a thermoplastic organic polymeric material the mixture of the latter material and the particulate superconducting material may be produced, for example, by blending a mixture of particles of the materials. Formation of the mixture may be assisted by effecting the mixing in the presence of a liquid diluent which is subsequently removed, e.g. in the presence of a solvent for the organic polymeric material. In a preferred method of mixing, which results in the formation of a particularly homogenous mixture, a mixture of organic material and superconducting particulate material, and optional liquid diluent, is blended on a twin-roll mill at a temperature at which the organic material becomes fluid so that the mixture forms a band on one of the rolls of the mill. The band is continuously or periodically removed from the roll and passed back through the nip between the rolls of the mill. This method of forming a mixture also serves to shape the mixture and results in production of a shaped article in the form of a sheet. Other forms of shaped article may be produced by using other shaping techniques. For example, the mixture may be shaped by extrusion, by injection moulding, or by compression moulding. Extrusion is a particularly suitable method for producing shaped articles having a regular shape, for example, shaped articles in the form of a film or tape, or in the form of a sheet, or in the form of a tube, rod or wire. Injection moulding and compression moulding are more suitable for use in the production of shaped articles of more complex shape.

The organic material in the mixture from which the shaped article of the invention may be produced may be a polymeric material which is itself cross-linkable. For example, the polymeric material may be a cross-linkable, or curable elastomer.

The organic material in the mixture from which the shaped article of the invention may be produced may be a polymerisable organic material, which may be polymerisable to a thermoplastic organic polymeric material or to a cross-linked organic polymeric material. In general, the polymerisable organic material will comprise a plurality of reactive groups such that a cross-linked organic material is formed by polymerisation.

Examples of suitable polymerisable organic materials include polyester resins containing a plurality of ethylenically unsaturated groups and epoxy resins containing a plurality of epoxy groups, and monomeric or oligomeric materials containing a plurality of polymerisable groups, e.g. a plurality of vinyl groups. Examples of polyester resins and epoxy resins are well known in the art.

The polymerisable organic material may be a liquid or a solid prior to polymerisation. It is preferred that, prior to polymerisation, the organic material is a solid which is melt processable, that is which behaves as a thermoplastic, in order that mixing and shaping processes may be used which have been hereinbefore described with reference to a thermoplastic organic polymeric material. In order to assist shaping a liquid diluent may be present in the composition. After the mixture has been formed into the desired shaped article the organic material in the composition may be treated, e.g. heated, in order to effect polymerisation of the organic material.

In the shaped article of the invention the proportion of particulate superconducting material is desirably as high as possible, and it should be sufficiently high that the shaped article is superconducting. In particular the proportion of particulate superconducting material is desirably greater than 50% by volume of the shaped article. The proportion of particulate superconducting material may be greater than 60% or even greater than 70% by volume. Higher proportions by volume of particulate superconducting material are preferred as there is then a greater possibility of the shaped article being not only superconducting in the sense of exhibiting the Meissner effect but also of being superconducting in the sense of exhibiting zero electrical resistivity at a temperature below the critical temperature. However, the proportion of particulate superconducting material in the mixtures from which the shaped article is to be produced should not be so great that the mixture cannot be shaped.

It will be appreciated that as the mixture of polymeric or polymerisable organic mechanical and particulate superconducting material of the ceramic type can be shaped by a variety of different techniques, e.g. injection moulding, compression moulding, extrusion and calendering, it is possible to produce the shaped article of the invention in a variety of shapes, both simple and complex, and in a variety of sizes, both large and small.

The shaped article of the invention which comprises a mixture of an organic polymeric material and a superconducting particulate material of the ceramic type does suffer from a disadvantage, as indeed does a shaped article comprising sintered particles of superconducting material of the ceramic type. Thus, at a temperature which is above the critical temperature not only is the superconducting property of the shaped article lost but the shaped article may virtually cease even to be a conductor of electricity at a temperature above the critical temperature. This loss of electrical conductivity, let alone the loss of superconductivity, may have serious consequences in the equipment of which the superconducting shaped article may form a part. This disadvantage is, however, overcome by a modified form of the shaped article of the invention, and in a further embodiment of the present invention there is provided a shaped article which possesses the property of superconductivity and which comprises a mixture of an organic polymeric material and a particulate superconducting material of the ceramic type and which also comprises an electrically conducting material. This modified form of shaped article is not only superconducting at a temperature below the critical temperature but it is also capable of conducting electricity at a temperature above the critical temperature.

The electrically conducting material in the modified form of shaped article is a material which is of course electrically conducting at normal temperatures, e.g. at a temperature of 25°C. The improved form of shaped article comprises an electrically conducting material of a type and in a proportion such that the shaped article is itself electrically conducting, particularly at a temperature above the critical temperature. Thus, the shaped article possesses the property of superconductivity at a temperature below the critical temperature yet at a temperature above the critical temperature the shaped article is electrically conducting, albeit not superconducting, and thus the disadvantage of loss of electrical conductivity at a temperature above the critical temperature is overcome.

The modified form of shaped article may be produced by a process which comprises forming a mixture of an organic material, which is polymeric or which is polymerisable, and a particulate superconducting material of the ceramic type, shaping the mixture, and if necessary polymerising the organic material, and contacting an electrically conducting material with the mixture either prior to or after formation of the shaped article.

The electrically conducting material in the modified form shaped article of the invention may take a variety of forms. For example, the electrically conducting material may itself be a particulate material, although such a form is not preferred as an undesirably high proportion of such a particulate material may be necessary in order to produce a shaped article which has the required electrical conductivity. A preferred form of electrically conducting material, which may be present in the shaped article in only a relatively small proportion in order to achieve the required electrical conductivity, is an electrically conducting material which is in a filamentary form.

The filamentary electrically conducting material may take a wide variety of different forms. For example, it may be in the form of continuous fibres, it may be in the form of chopped random fibres of relatively short length, it may be in the form of a woven mat, it may be may be in the form of a wire or a plurality of wires, it may be in the form of a mesh, e.g. as in a wire mesh, or it may even be in the form of an expanded sheet, that is a sheet produced by forming a plurality of slits in a sheet and expanding the sheet.

The means by which the electrically conducting material is incorporated into the shaped article, and the stage in the production of the shaped article at which the electrically conducting material is incorporated, will depend on the nature of the material. For example, where the electrically conducting material is in particulate form, or where it is in the form of chopped random fibres, the electrically conducting material may be mixed with the organic material and with the particulate superconducting material prior to the formation of the shaped article, and prior to polymerisation of the organic material where the latter material is a polymerisable organic material. The mixture may be formed by the methods as hereinbefore described. Alternatively, the electrically conducting material may be incorporated during production of the shaped article, for example the electrically conducting material may be added to the mixture of organic material and particulate superconducting material when the latter mixture is being formed into a sheet by calendering on a twin-roll mill. On the other hand, where the electrically conducting material is in the form of continuous fibres, a mat, a mesh, or an expanded sheet, it is generally not possible to incorporate the electrically conducting material into the mixture of organic polymeric material and particulate superconducting material prior to production of the shaped article as the shaping process may destroy the structure of the electrically conducting material. Thus, where the electrically conducting material is in the form of continuous fibres, a mat, a mesh, or an expanded sheet, it is preferred to incorporate the electrically conducting material after formation on the shaped article. For example, the electrically conducting material may be laminated with the shaped article by pressing the material into a surface of the shaped article, e.g. in the case where the organic material is an organic polymeric material when the latter material is in a heat softened state, or, in the case where the organic material is an organic monomeric material, prior to polymerisation of the latter material, or at least prior to completion of the polymerisation. Such a lamination step is particularly readily effected where the shaped article is in the form of a sheet, and in this case the lamination may be effected by passing the shaped article and the filamentary electrically conducting material through the nip between the rolls of a twin roll mill. The laminate may comprise a layer of a mixture or organic polymeric material and a particulate superconducting material and a layer of a filamentary electrically conducting material, or it may comprise a plurality of such layers, for example, alternating layers, e.g. a layer of electrically conducting material sandwiched between two layers of a mixture of organic polymeric material and particulate superconducting material.

Any suitable dimensions may be chosen for the filamentary electrically conducting material, for example a diameter of the filaments in the range 5 mm to 0.01 micron.

The electrically conducting material may be any material which has a suitable electrical conductivity at normal temperature, that is at a temperature of 25°C. The material may be a metal, for example, steel, copper, aluminium, silver or indeed any electrically conducting metal. The electrically conducting material, particularly when in filamentary form, may comprise a core of an electrically non-conducting material have an outer coating of an electrically conducting material, for example it may comprise filaments of an organic polymeric material having an outer metal containing.

The electrically conducting material desirably has an electrical resistivity of not more than $10^{-2}$ ohm cm, and it preferably has an electrical resistivity of not more than $10^{-4}$ ohm cm.

The electrical conductivity which is required in the shaped article of the invention at normal temperature will depend to some extent on the manner of use of the shaped article. However, in general the shaped article will itself have an electrical resistivity of not more than $10^{-4}$ ohm cm.

The proportion of electrically conducting material in the shaped article of the invention will depend to some extent on the electrical conductivity which is required in the shaped article and on the nature of the electrically conducting material. The filamentary form of electrically conducting material possesses the advantage that the proportion by volume of such material which is required to achieve a given electrical conductivity may be relatively low, and it may be as low as 1% by volume of the shaped article, although it is preferably at least 5% by volume. The proportion of electrically conducting material in the shaped article is preferably not high as the presence of a high proportion of such material may have an adverse effect on the achievement of superconductivity in the shaped article. It is preferred that the electrically conducting material is present in a proportion of not more than 25% by volume of the shaped article.

The presence in the shaped article of electrically conducting material assists in the achievement of good electrical connection to the shaped article.

Depending on whether the shaped article of the invention is superconducting in the sense of exhibiting zero electrical resistivity, or merely exhibiting the Meissner effect, at temperatures below the critical temperature uses for the shaped article include uses in power transmission lines which in use result in little or no loss of power, in electric motors, in magnetic levitation applications such as transportation systems which operate on the magnetic levitation principle, in scientific instruments, e.g. in superconducting quantum interference devices (SQUIDS), and in structures for use in magnetic screening, e.g. in the screening of electrical equipment.

The invention will now be described with the aid of the following examples in which, unless otherwise stated, all parts are expressed as parts by volume.

EXAMPLE 1

A particulate mixture of $BaCO_3$, CuO, and $Y_2O_3$ in proportions by weight of 52.9:32.0:15.1 was ground and thoroughly mixed using a mortar and pestle and the mixture was placed in an oven in an atmosphere of air at a temperature of 900°C for 12 hours. The mixture was then removed from the oven, cooled, and reground using a mortar and pestle, and then placed in an open alumina container and heated in an oven at 930°C for 12 hours. During the heating a flow of oxygen was passed through the oven. The oven and contents were then cooled at a rate of 1°C per minute until a temperature of 400°C was reached, the temperature of 400°C was maintained for 2 hours, and thereafter the oven and contents were cooled to ambient temperature at a rate of 1°C per minute. The flow of oxygen was maintained during the cooling procedure.

The particles of the material removed from the alumina container were slightly aggregated and the material was ground using a mortar and pestle to convert the material to a powder from having a size in the range of approximately 1 to 10 microns. The particulate material had a composition corresponding approximately to the formula $YBa_2Cu_3O_7$.

Superconductivity in the particulate material was demonstrated by cooling the material in liquid nitrogen, placing the material on the surface of an electromagnet, and activating the electromagnet. The particulate material was repelled by magnet. The particulate material thus exhibited the Meissner effect.

4.76 parts of the particulate material was mixed with 1.82 parts of polyvinyl butyral and with 3.64 parts of cyclohexanone, and the viscous composition was passed repeatedly through the nip between the rolls of a twin-roll mill at ambient temperature. The composition which adhered to one of the rolls of the mill was repeatedly removed from the roll, turned at right angles, and passed back through the nip in order to produce a homogeneously mixed composition. During the mixing procedure on the twin-roll mill some of the cyclohexanone evaporated. The sheet which was produced on the twin-roll mill was removed from the mill and heated in an oven at 90°C in order to remove the remainder of the cyclohexanone from the sheet.

The sheet, which comprised 72.3% by volume of particulate superconducting material and was flexible, was then cooled in liquid nitrogen and a part of the sheet was tested for the Meissner effect following the procedure hereinbefore described. The sheet exhibited the Meissner effect.

EXAMPLE 2

A composition comprising

EP 0 309 169 A2

|  | parts by volume |
|---|---|
| Particulate superconducting material produced as described in Example 1 | 53.2 |
| Tetrahydrofurfuryl methacrylate | 16.7 |
| Oligourethane methacrylate* | 12.1 |
| Copolymer containing units of vinyl butyral and vinyl alcohol - Pioloform BS 18 - Wacker Chemie GmbH | 17.9 |
| Tertiary butylperpivolate | 0.1 |

*a reaction product of hydroxyl ethyl methacrylate and an isocyanate oligomer.

was mixed on a twin-roll mill following the procedure described in Example 1 and the composition in the form of a sheet was removed from the mill, placed in a mould, pressed at a temperature of $100^\circ$C for 15 minutes in order to polymerise the tetrahydrofurfuryl methacrylate and the oligourethane methacrylate.

The shaped article removed from the mould was tested for the Meissner effect following the procedure described in Example 1. The shaped article exhibited the Meissner effect.

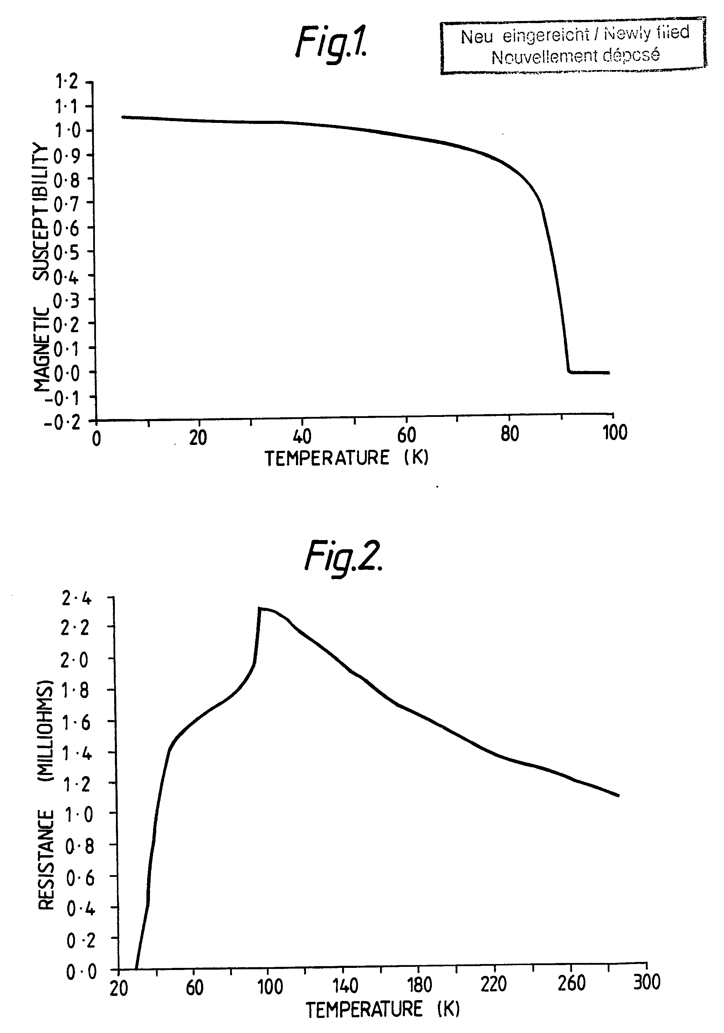

The magnetic susceptibility of the shaped article was measured as a function of temperature at 1kHz in the peak field of 1 microtesla. The variation of magnetic susceptibility with temperature is shown in Figure 1.

The electrical resistance of the shaped article as a function of temperature was also measured and the variation of electrical resistance is shown in Figure 2.

EXAMPLE 3

The procedure of Example 2 was repeated except that the composition which was used comprised

|  | parts by volume |
|---|---|
| Particulate superconducting material produced as described in Examaple 1 | 62.3 |
| Tetrahydrofurfuryl methacrylate | 23.9 |
| Copolymer containing units of vinyl butyral and vinyl alcohol - Pioloform BS 18 - Wacker Chemie GmbH | 13.6 |
| Tertiary butylperpivolate | 0.1 |

The shaped article removed from the mould was cooled to a temperature of $77^\circ$K at which temperature it exhibited the Meissner effect.

EXAMPLE 4

A composition comprising

8

|  | parts by volume |
|---|---|
| Particulate superconducting material produced as in Example 1 | 60.6 |
| Tetrahydrofurfuryl methacrylate | 14.8 |
| Oligourethane methacrylate* | 10.7 |
| Copolymer containing units of vinyl butyral and vinyl alcohol - Pioloform BS 18 - Wacker Chemie GmbH | 13.8 |
| Tertiary butylperpivolate | 0.1 |

*a reaction product of hydroxyl ethyl methacrylate and an isocyanate oligomer.

was mixed on a twin-roll mill, and the viscous composition was passed repeatedly through the nip between the rolls of the mill at ambient temperature. The composition which adhered to one of the rolls of the mill was repeatedly removed from the roll, turned at right angles, and passed back through the nip in order to produce a homogeneously mixed composition.

The composition was removed from the mill in the form of a thin sheet. A mesh in the form of a woven structure formed from 0.09 mm diameter brass wire was sandwiched between two samples of the sheet and the resulting composite structure was pressed under an applied pressure of 5 MPa and heated at 100°C for 15 minutes in order to polymerise the tetrahydrofurfuryl methacrylate and the oligourethane methacrylate. The resultant composite structure was 2 mm thick and contained 4.9% by volume of brass mesh.

Superconductivity in the composite structure was demonstrated by cooling the structure in liquid nitrogen on the surface of a magnet. The structure was repelled by the magnet and was suspended above the surface of the magnet. The composite structure thus exhibited the Meissner effect.

The presence of the brass mesh in the composite structure ensured that the structure was able to conduct electricity at a temperature substantially above that at which superconductivity was no longer present in the composite structure.

The composite structure was able to conduct electricity at 25°C and had a resistivity of $7 \times 10^{-6}$ ohm cm.

**Claims**

1. A shaped article which possesses the property of superconductivity and which comprises a mixture of an organic polymeric material and a particulate superconducting material of the ceramic type.

2. A shaped article as claimed in claim 1 in which the particulate superconducting material has a critical temperature which is not lower than 77°K.

3. A shaped article as claimed in claim 1 or claim 2 in which the particulate superconducting material is of the oxide type.

4. A shaped article as claimed in claim 3 in which the particulate superconducting material comprises at least one element of the lanthanide series, including lanthanum itself and scandium and yttrium, at least one alkaline earth element, and at least one transition element.

5. A shaped article as claimed in claim 4 in which in the particulate superconducting material the alkaline earth element is selected from magnesium, calcuim, strontium and barium, and the transition element is selected from copper, titanium, tungsten, zirconium, tantalum, niobium, and vanadium.

6. A shaped article as claimed in claim 4 or claim 5 in which the particulate superconducting material is of the yttrium - barium - copper - oxide type.

7. A shaped article as claimed in claim 6 in which the particulate superconducting material has a formula $YBa_2Cu_3O_x$ where x is is 6.5 to 7.2.

8. A shaped article as claimed in claim 4 or claim 5 in which the particulate superconducting material is of the lanthanum - barium - copper oxide type.

9. A shaped article as claimed in any of claims 1 to 8 in which the particulate superconducting material has a size of not greater than 100 microns.

10. A shaped article as claimed in any one of claims 1 to 9 in which the organic polymeric material is a thermoplastic material.

11. A shaped article as claimed in any one of claims 1 to 9 in which the organic polymeric material is a cross-linked material.

12. A shaped article as claimed in any one of claims 1 to 11 in which the proportion of particulate superconducting material is greater than 50% by volume of the shaped article.

13. A shaped article as claimed in claim 12 in which the proportion of particulate superconducting material is greater than 60% by volume of the shaped article.

14. A process for the production of a shaped article which possesses the property of superconductivity which process comprises forming a mixture of an organic material, which is polymeric or which is polymerisable, and a particulate superconducting material of the ceramic type, shaping the mixture, and if necessary polymerising the organic material.

15. A process as claimed in claim 14 in which the mixture which is shaped has a composition as claimed in any one of claims 2 to 13.

16. A process as claimed in claim 14 or claim 15 in which the mixture which is shaped comprises a liquid diluent.

17. A process as claimed in any one of claims 14 to 16 in which the mixture is shaped by injection moulding, compression moulding, calendering or extrusion.

18. A shaped article which possesses the property of superconductivity and which comprises a mixture of an organic polymeric material and a particulate superconducting material of the ceramic type and which also comprises an electrically conducting material.

19. A shaped article as claimed in claim 18 in which the electrically conducting material is a particulate material.

20. A shaped article as claimed in claim 18 in which the electrically conducting material is in a filamentary form.

21. A shaped article as claimed in any one of claims 18 to 20 in which the electrically conducting material is a metal.

22. A shaped article as claimed in any one of claims 18 to 21 in which the electrically conducting material has an electrical resistivity of not more than $10^{-4}$ ohm cm.

23. A shaped article as claimed in any one claims 18 to 22 in which the electrical resistivity is not more than $10^{-2}$ ohm cm.

# Fig.1.

# Fig.2.